(19) Europäisches Patentamt
European Patent Office
Office européen des brevets

(11) EP 3 290 863 A1

(12) DEMANDE DE BREVET EUROPEEN

(43) Date de publication:
**07.03.2018 Bulletin 2018/10**

(51) Int Cl.:
***G01C 19/62*** *(2006.01)* *G01R 33/26* *(2006.01)*

(21) Numéro de dépôt: **17188269.9**

(22) Date de dépôt: **29.08.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **02.09.2016 FR 1658174**

(71) Demandeur: **Commissariat à l'énergie atomique et aux énergies alternatives**
**75015 Paris (FR)**

(72) Inventeurs:
- **PALACIOS LALOY, Augustin**
**38000 GRENOBLE (FR)**
- **LE PRADO, Matthieu**
**38160 SAINT-MARCELLIN (FR)**

(74) Mandataire: **Brevalex**
**95, rue d'Amsterdam**
**75378 Paris Cedex 8 (FR)**

# (54) DISPOSITIF DE DÉTECTION DE RÉSONANCE MAGNÉTIQUE NUCLÉAIRE DE TYPE SEOP À DOUBLE CELLULE

(57) L'invention porte sur un dispositif de détection de résonance magnétique nucléaire qui comprend une enceinte (2) contenant un mélange gazeux qui comprend un alcalin et deux espèces de gaz noble, un générateur (3) d'un champ magnétique statique orienté selon un axe de mesure (4) du dispositif, un premier laser pompe (5) pour conférer un sens d'orientation à l'alcalin le long dudit axe de mesure, cette orientation étant transférée aux deux espèces de gaz noble par collision d'échange de spin.

L'enceinte comprend une première cellule (21) agencée de manière à pouvoir être éclairée par le premier laser pompe (5), une deuxième cellule (22), et une connexion (23) de diffusion du mélange gazeux reliant la première et la deuxième cellule.

Le dispositif comprend en outre un second laser pompe (7) configuré pour éclairer la deuxième cellule et pour orienter l'alcalin dans la deuxième cellule alternativement, et selon des périodes temporelles correspondantes, selon un sens identique et selon un sens opposé au sens d'orientation conféré à l'alcalin dans la première cellule.

Un photodétecteur agencé en regard de la deuxième cellule permet de détecter la résonance magnétique nucléaire des deux espèces de gaz noble

1
5
21
23
6
22
7
2
4
8
3
FIG. 1



Printed by Jouve, 75001 PARIS (FR)

## Description

### DOMAINE TECHNIQUE

Le domaine de l'invention est celui des gyroscopes utilisés pour permettre la navigation inertielle, à savoir la navigation en l'absence de tout repère extérieur par l'intégration des équations du mouvement. L'invention concerne les gyroscopes à résonance magnétique nucléaire qui utilisent les propriétés magnétiques des atomes pour réaliser des mesures de rotation, et plus particulièrement ceux du type à pompage optique par échange de spin (SEOP pour « spin exchange optical pumping »).

### ÉTAT DE LA TECHNIQUE ANTÉRIEURE

Les gyroscopes les plus couramment utilisées actuellement en navigation inertielle sont des gyroscopes optiques à effet Sagnac qui présentent cependant l'inconvénient d'être relativement encombrants. Ce n'est pas le cas des gyroscopes à résonance magnétique nucléaire (RMN) qui peuvent faire l'objet d'une miniaturisation et pourraient être utilisés dans de nombreuses applications innovantes, par exemple pour compléter des données GPS en milieu urbain à destination d'automobilistes ou de piétons, pour aider au repérage d'équipes de secours en milieu sous-terrain, pour augmenter l'autonomie de drones en milieu hostile, etc.

Les gyroscopes RMN exploitent la résonance de noyaux de gaz nobles dans un champ magnétique et mesurent la vitesse de rotation $w_R$ comme un décalage à la fréquence de Larmor de précession des gaz nobles. En absence de mouvement, on observe une précession des spins nucléaires sous l'effet d'un champ magnétique typiquement de 10-1000 $\mu$T. Dans le référentiel inertiel, cette précession s'effectue à une fréquence angulaire $\gamma B_0$ qui ne dépend que du champ magnétique $B_0$ et du rapport gyromagnétique $\gamma$ des noyaux (constante physique). Lorsque le gyroscope tourne, la précession vue depuis le référentiel du gyroscope subit un décalage égal à la fréquence angulaire de la rotation mécanique du porteur: $w = \gamma B_0 \pm w_R$. Le signe du décalage dépend de la direction de la rotation par rapport à la direction de précession des spins.

A l'heure actuelle deux méthodes optiques sont utilisées pour produire des gaz nobles hyperpolarisés.

La méthode de pompage optique par échange de spins (SEOP en anglais, pour « spin exchange optical pumping) à partir d'un métal alcalin a été la première méthode proposée historiquement. Elle repose sur le transfert du moment angulaire de photons vers les spins électroniques des atomes alcalins suivie du transfert, par collision, du moment angulaire de ces spins électroniques des atomes alcalins vers les spins nucléaires des atomes des gaz rares.

L'autre méthode dite d'échange de métastabilité (MEOP pour « metastability exchange optical pumping) ne nécessite pas d'avoir recours à un métal alcalin comme intermédiaire de pompage. Selon cette méthode, quelques atomes de gaz noble sont excités par une décharge électrique (plasma) à un état d'énergie métastable où ils peuvent absorber une lumière et être optiquement polarisés. L'échange de spin s'opère alors entre l'état excité métastable et l'état fondamental du gaz noble. Une difficulté avec cette méthode MEOP est que la présence d'atomes en état excité dans la cellule de mesure introduit un biais considérable à cause de processus connus comme « circulation de cohérence ». Il a par ailleurs été démontré dans l'artice de T.Xia et al. intitulé « Polarization and hyperfine transitions of metastable 129Xe in discharge cells », Physical Review, Vol. 81, Iss. 3 - Mars 2010, que cet échange de métastabilité ne fonctionne pas pour le xénon mais uniquement pour l'hélium, ce qui ne permet pas de disposer de deux isotopes de spin nucléaire non nul pour assurer la mesure.

Une architecture performante de gyroscope RMN de type SEOP est décrite dans le brevet US 4,157,495. Ce gyroscope utilise une cellule contenant deux espèces de gaz noble comme éléments sensibles, ainsi qu'un alcalin (typiquement du rubidium ou du césium). Cette cellule est éclairée par un laser de pompe, avec une polarisation circulaire et une longueur d'onde accordée à une transition de l'alcalin (typiquement la raie D1, à 795nm pour le rubidium). Sous l'effet de ce laser, les spins électroniques de l'alcalin sont orientés dans la direction de propagation du faisceau de pompe. Par le biais d'un phénomène d'échange de spin, une partie de cette orientation est transférée vers les spins nucléaires des deux espèces de gaz nobles, qui sont ainsi orientées dans cette même direction. L'application de champs radiofréquences appropriées (dont les fréquences se trouvent dans la gamme allant des centaines de Hz aux kHz) induit une précession de ces spins nucléaires à leur fréquence de Larmor autour du champ statique. Le décalage de cette précession lorsque le gyroscope tourne est suivie à l'aide de l'alcalin qui est opéré comme magnétomètre intégré à l'aide d'un autre champ radiofréquence (dans la gamme des dizaines à centaines de kHz) colinéaire au champ magnétique statique. La dynamique résultante est observé à l'aide d'un laser de sonde, typiquement polarisé linéairement (configuration de mesure Faraday).

Du fait de la différence de sensibilité que présentent les deux espèces de gaz nobles vis-à-vis du champ magnétique crée par l'alcalin opéré comme magnétomètre, cette architecture est sujette à une forte sensibilité à la dérive thermique. On vient donc généralement utiliser pour les espèces de gaz noble les deux isotopes du xénon $^{129}$Xe et $^{131}$Xe car ils présentent l'avantage d'avoir le plus faible écart de sensibilité parmi tous les gaz nobles.

Toutefois, pour permettre la navigation inertielle, on vise une dérive de l'ordre de 0.01°/h et un angle de marche aléatoire (« angle of random-walk », ARW) de l'ordre de $0.002°/\sqrt{h}$. De tels objectifs se traduisent par un besoin de stabilisation thermique meilleur que 0.5 mK, y compris lorsque l'on a recours aux deux isotopes du xénon $^{129}Xe$ et $^{131}Xe$ en tant qu'éléments sensibles.

Un tel niveau de stabilité thermique pour un capteur miniature reste contraignant et réduit fortement ses potentialités à permettre la navigation dans des environnements hors laboratoire et donc soumis à des fluctuations thermiques significatives.

Il a été proposé dans le brevet US 8,698,493 B2 de pomper l'alcalin de manière synchronisée avec la dynamique des gaz nobles de manière à ce que le champ magnétique de l'alcalin exerce un couple nul en moyenne sur les gaz nobles. Ce mode de pompage permet potentiellement de réduire la dérive thermique de plusieurs ordres de grandeur et est en cours de validation expérimentale. Il présente cependant deux inconvénients principaux.

Il est en effet nécessaire d'appliquer des impulsions très brèves et intenses de champ magnétique à l'intérieur d'un blindage magnétique contenant les différents organes du gyroscope RMN. Ces impulsions induisent inévitablement des courants de Foucault dans les matériaux du blindage magnétique (typiquement des matériaux ferreux tel que la ferrite ou des alliages de type mu-métal) qui peuvent engendrer un comportement erratique du gyroscope si le blindage est proche de l'élément sensible, ou a contrario nécessiter de prévoir un gyroscope de taille considérable si on espace ces deux organes (c'est cette dernière option qui est utilisée en laboratoire). Par ailleurs, la complexité des calculs requis pour assurer le synchronisme avec la dynamique des gaz nobles et la fragilité de l'accrochage à celui-ci peuvent constituer des obstacles importants pour réaliser un capteur robuste et miniature.

## EXPOSÉ DE L'INVENTION

On cherche donc une solution pour réduire la sensibilité à la dérive thermique d'un gyroscope RMN de type SEOP qui ne s'accompagne pas des inconvénients susmentionnés.

A cet effet, l'invention propose un dispositif de détection de résonance magnétique nucléaire du type à pompage optique par échange de spin, comprenant une enceinte contenant un mélange gazeux qui comprend un alcalin et deux espèces de gaz noble, un générateur d'un champ magnétique statique orienté selon un axe de mesure du dispositif, et un premier laser pompe pour conférer un sens d'orientation à l'alcalin le long dudit axe de mesure, cette orientation étant transférée aux deux espèces de gaz noble par collision d'échange de spin. L'enceinte comprend une première cellule agencée de manière à pouvoir être éclairée par le premier laser pompe, une deuxième cellule, et une connexion de diffusion du mélange gazeux reliant la première et la deuxième cellule. Un second laser pompe éclaire la deuxième cellule et est configuré pour orienter l'alcalin dans la deuxième cellule alternativement, et selon des périodes temporelles correspondantes, selon un sens identique et selon un sens opposé au sens d'orientation conféré à l'alcalin dans la première cellule par le premier laser pompe.

Certains aspects préférés mais non limitatifs de ce dispositif sont les suivants :

- il comprend en outre un laser sonde agencé de manière à pouvoir éclairer la deuxième cellule, et un photodétecteur agencé pour recevoir la lumière émise par le laser sonde après passage à travers la deuxième cellule ;
- la connexion comprend un conduit capillaire ou une paroi poreuse ;
- la connexion débouche dans la deuxième cellule en deux points de la paroi de la deuxième cellule, les droites normales à la paroi auxdits points étant contenues dans des plans qui sont parallèles à l'axe de mesure du dispositif et qui forment un angle droit entre eux, et chacun desdits points est situé dans un plan médian de la deuxième cellule qui est perpendiculaire à l'axe de mesure ;
- l'enceinte comprend un queusot uniquement au niveau de la première cellule ;
- l'enceinte est issue de gravure d'un substrat ;
- il comprend en outre un régulateur thermique apte à conférer des inhomogénéités de température à la paroi de la première cellule.

L'invention porte également sur une centrale de navigation inertielle incorporant un tel dispositif.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma d'un dispositif selon l'invention ;
- la figure 2 illustre une variante de réalisation de l'invention permettant une réduction de la sensibilité du dispositif selon l'invention aux effets quadrupolaires ;
- les figures 3a et 3b représentent deux variantes d'un dispositif selon l'invention micro-fabriqué selon les procédés connus en micro-électronique.

## EXPOSÉ DÉTAILLÉ DE MODES DE RÉALISATION PARTICULIERS

L'invention porte sur un dispositif de détection de résonance magnétique nucléaire du type à pompage optique par échange de spin (SEOP), ainsi que sur une centrale de navigation inertielle incorporant un tel dispositif.

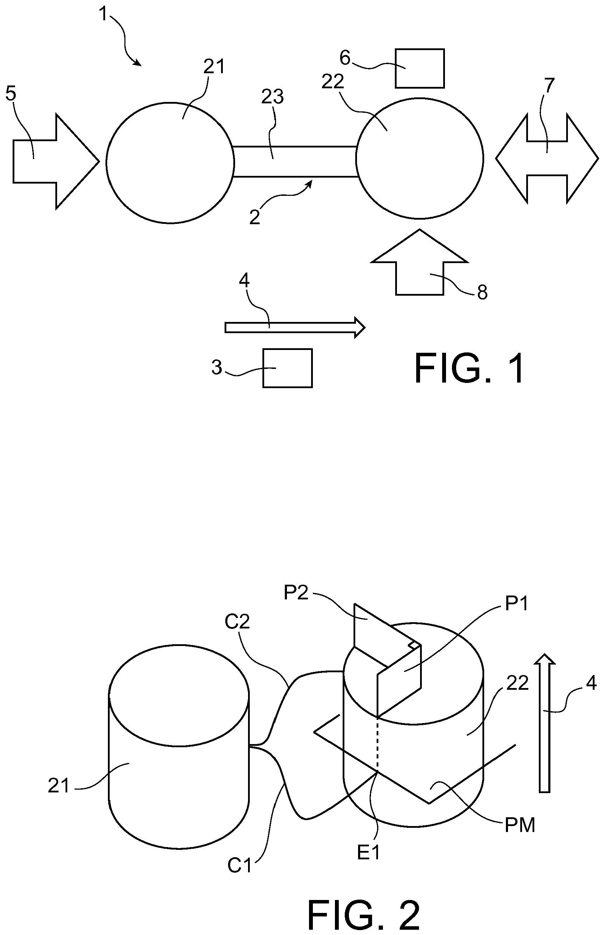

En référence à la figure 1, un tel dispositif 1 comprend de manière conventionnelle une enceinte 2 contenant un mélange gazeux qui comprend un alcalin, par exemple du rubidium, et deux espèces de gaz noble, avantageusement deux isotopes d'un même gaz, tels que par exemple les deux isotopes du xénon $^{129}Xe$ et $^{131}Xe$.

Cette enceinte est placée dans un champ magnétique statique orienté selon un axe de mesure du dispositif représenté par la flèche 4. Ce champ est généré par un générateur 3 qui prend la forme de bobines ou d'aimants permanents, et le dispositif va permettre de détecter une rotation autour de l'axe de mesure. On peut ainsi utiliser dans une centrale de navigation inertielle trois dispositifs selon l'invention, chacun associé à un générateur de champ magnétique statique le long d'un axe de mesure respectif permettant de couvrir les trois axes d'un repère orthonormé.

Le dispositif 1 comprend en outre un premier laser pompe 5 pour conférer un sens d'orientation à l'alcalin le long dudit axe de mesure 4, cette orientation étant transférée aux deux espèces de gaz noble par collision d'échange de spin.

L'enceinte 2 utilisée dans le dispositif selon l'invention présente l'originalité de comporter deux cellules 21, 22 reliées entre elles par une connexion 23 de diffusion du mélange gazeux. L'intégralité du volume de l'enceinte à double cavité est remplie du même mélange gazeux (alcalin + deux gaz nobles + autres constituants annexes). La connexion 23 peut prendre la forme d'un conduit capillaire (i.e. long et fin), dont la dimension caractéristique (diamètre typiquement) est réduite par rapport à la dimension caractéristique (diamètre par exemple) des cellules 21, 22, par exemple au moins dix fois plus faible. Le conduit capillaire 23 présente par exemple un facteur de forme (typiquement ratio longueur sur diamètre) supérieur à 100 :1 (soit globalement une longueur de l'ordre du millimètre et un diamètre de l'ordre du micromètre).

Une telle enceinte permet de séparer spatialement les fonctions de préparation de l'état de l'élément sensible par SEOP (dans la première cellule, dite de polarisation) et de mesure de la dynamique de cet élément sensible (dans la deuxième cellule, dite de mesure). La séparation spatiale des fonctions se base sur le fait qu'un atome de gaz noble peut subir plus de 1000 collisions avec la paroi de l'enceinte avant de perdre son orientation, alors qu'un atome d'alcalin relaxe à chaque collision avec la paroi. Ainsi l'état d'orientation du gaz noble est le même dans les deux cavités alors que celui de l'alcalin peut être complètement différent des deux côtés.

La diminution de la densité d'alcalin polarisé dans la cellule de mesure (et donc la dérive thermique) est proportionnelle à la réduction de la dimension caractéristique de la connexion 23 par rapport à la dimension caractéristique des cellules 21, 22. L'ordre de grandeur où cette diminution est utile va de quelques dizaines de fois plus petit (dérive imposant une stabilité thermique de l'ordre de la dizaine de mK) jusqu'à quelques milliers de fois plus petits.

La première cellule 21 et le premier laser pompe 5 sont agencés de manière à ce qu'en utilisation le premier laser pompe 5 éclaire la première cellule 21 et oriente les atomes d'alcalin présents dans la première cellule dans un sens d'orientation le long de l'axe de mesure 4. Cette orientation est ensuite transférée par échange de spin aux atomes de gaz noble présents dans la première cellule. Le premier laser pompe vient ainsi réaliser un pompage optique longitudinal des atomes d'alcalin présents dans la première cellule pour qu'ils adoptent toujours le même sens d'orientation.

La deuxième cellule 22 est quant à elle destinée à la mesure de l'état des atomes de gaz noble à l'aide d'au moins un laser et d'un photo-détecteur 6 permettant de détecter la résonance magnétique nucléaire des deux espèces de gaz noble dans la deuxième cellule.

L'au moins un laser associé à la deuxième cellule est notamment destiné à orienter l'alcalin dans la deuxième cellule de manière colinéaire au champ magnétique statique. L'au moins un laser comprend ainsi un second laser pompe.

Dans un mode de réalisation possible, un seul laser est associé à la deuxième cellule et assure à la fois l'orientation de l'alcalin et la mesure de sa dynamique, au moyen d'une configuration à 45°. Un tel laser n'est pas co-linéaire au champ magnétique statique mais l'orientation qu'il confère l'est car les composantes transverses se moyennent à zéro. Plus particulièrement, la projection sur le champ magnétique statique agit comme pompe, tandis que la projection sur le plan transverse permet d'assurer la mesure de la dynamique par le suivi de l'intensité lumineuse transmise selon une configuration de mesure bien connue dans le domaine sous le nom de mesure Dehmelt.

Comme représenté sur la figure 1, on associe de préférence deux lasers à la deuxième cellule 22 : un second laser pompe 7 pour orienter les alcalins le long de l'axe de mesure et un laser sonde 8 agencée de manière à pouvoir éclairer la deuxième cellule de telle sorte que le photodétecteur 6 reçoive la lumière émise par le laser sonde 8 après passage à travers la deuxième cellule 22. Le laser sonde 8 est typiquement orthogonal au second laser pompe, et assure la mesure de la dynamique de l'alcalin dans la deuxième cellule par effet Faraday ou par absorption (dans une configuration dite de Dehmelt). Une source radiofréquence (non représentée) est par ailleurs associée à la deuxième cellule. Elle fournit un champ magnétique orthogonal au faisceau du laser sonde 8 et fonctionne comme auto-oscillateur comme décrit dans le brevet US 4,157,495.

Dans le cadre de l'invention, le second laser pompe (dans l'un ou l'autre des deux modes de réalisation mentionnés ci-dessus) est configuré pour orienter l'alcalin dans la deuxième cellule alternativement, et selon des périodes temporelles correspondantes, selon un sens identique et selon un sens opposé au sens d'orientation conféré à l'alcalin dans la première cellule par le premier laser pompe. En d'autres termes, l'alcalin dans la deuxième cellule est orienté dans un sens puis dans l'autre le long de l'axe de mesure 4, l'orientation moyenne étant nulle. Le second laser pompe vient ainsi réaliser un pompage optique longitudinal des atomes d'alcalin présents dans la deuxième pour qu'ils soient alternativement orientés dans un sens puis dans l'autre le long de l'axe de mesure 4.

Contrairement à l'architecture décrite dans le brevet US 8,698,493 B2, le pompage de l'alcalin dans la deuxième cellule n'a pas à être réalisé de manière synchronisée avec la dynamique des gaz nobles. Les périodes temporelles n'ont donc pas à être synchrones de cette dynamique.

Sans pour autant que cela ne soit limitatif de l'invention, ces périodes sont de préférence choisies suffisamment courtes vis-à-vis du temps de relaxation de la polarisation des spins nucléaires des atomes de gaz nobles, Ainsi, l'orientation donnée par échange de spin aux gaz nobles du fait du pompage de l'alcalin par le second laser pompe dans la deuxième cellule est négligeable par rapport à celle conférée par le premier laser pompe dans la première cellule. Ce temps de relaxation dépend de la taille de la cellule et de l'état de surface des parois (dans des cellules de 2 mm de côté et en présence d'alcalin, il est de l'ordre de 30 secondes, tandis qu'avec des cellules sphériques de 20 cm de diamètre et en distillant l'alcalin, il peut être de plusieurs heures), et on choisit pour ces périodes des durées inférieures d'un facteur 10 à 100 à ce temps de relaxation. Les périodes sont ainsi comprises entre la seconde et la dizaine de minutes, et sont de préférence de l'ordre de quelques dizaines de secondes.

La limite supérieure de ces périodes est fixée par le temps conduisant à l'atteinte de la dérive dans le moyennage des sorties du dispositif. Sur un graphe de la variance d'Allan, cela correspond à la coordonnée temporelle à laquelle on atteint le minimum de la variance (cette variance minimale correspondant quant à elle à la dérive). La limite inférieure de ces périodes de modulation de l'orientation de l'alcalin dans la deuxième cellule n'a aucun lien avec le temps de vie des gaz nobles car cette modulation affecte directement uniquement l'alcalin. Cette limite inférieure est donc plutôt fixée par le temps de vie des alcalins, nettement plus court que celui des gaz nobles, lequel est déterminé essentiellement par la puissance de pompage. L'ordre de grandeur est 0.1 s à quelques ms.

A l'aide de l'enceinte à double cavité et de la configuration du second laser pompe, le couple exercé par l'alcalin sur les gaz noble dans la deuxième cellule (cellule de mesure) est réduit de plus d'un facteur 10 par rapport à l'architecture du brevet US 4,157,495, voire même de plus d'un facteur 100 notamment lorsque le facteur de forme du conduit capillaire est supérieur à 65. La dérive thermique décroit donc de manière significative pour des temps nettement supérieurs à la période de modulation du faisceau du second laser pompe.

Par ailleurs, dans l'architecture du brevet US 4,157,495, un compromis doit être recherché entre la puissance du laser pompe qui assure la polarisation de l'alcalin, et donc du gaz noble, mais qui détermine aussi le temps de relaxation des alcalins utilisés comme magnétomètre intégré et donc la relation signal-à-bruit de la mesure. En effet, la puissance doit être fixée à un niveau élevé de manière à assurer la polarisation du gaz noble par échange de spin. Par contre, cela induit un élargissement de la raie de résonance du rubidium qui est alors dominé par l'élargissement fixé par le pompage. Or la séparation spatiale des fonctions proposée par l'invention permet de diminuer la puissance du laser de pompe sur la cellule de mesure (par comparaison avec la puissance du laser pompe de l'architecture de l'art antérieur), typiquement sous le mW, sans affecter le taux de polarisation des atomes de gaz noble. Alternativement ou en combinaison, il est également possible d'augmenter la puissance du laser de pompe sur la cellule de polarisation, sans craindre une dégradation du rapport signal-à-bruit.

L'enceinte de l'invention peut en outre permettre de réduire la sensibilité du dispositif de détection aux effets quadrupolaires qui constituent un biais légèrement moins significatif que le biais thermique. Notamment le queusot qui est utilisé pour permettre de faire le vide dans l'enceinte est source d'une asymétrie très pénalisante du point de vue des effets quadrupolaires. En venant former le queusot uniquement au niveau de la première cellule, un écart à la sphéricité de la deuxième cellule (cellule de mesure) n'est amené que par la connexion de diffusion du mélange gazeux entre les deux cellules et les atomes utilisés pour la mesure présentent donc un décalage de fréquence quadrupolaire réduit (ils ne sont sensibles que de manière marginale au queusot présent dans l'autre cellule).

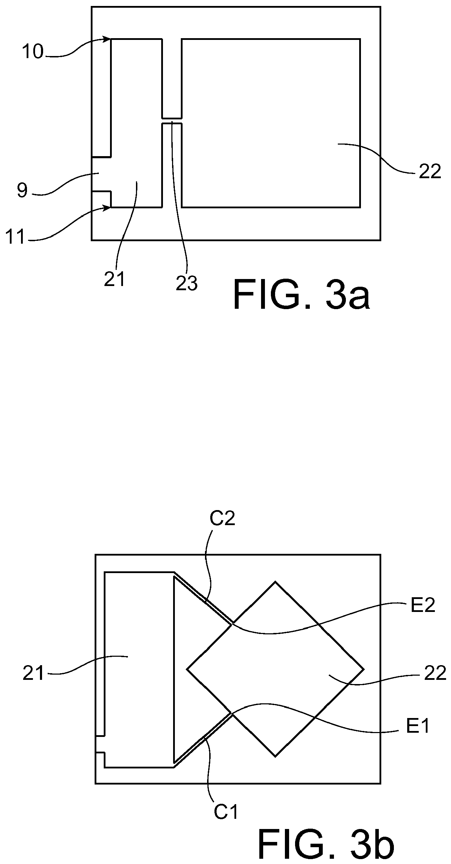

Comme représenté sur les figures 2 et 3b, dans une variante de réalisation la connexion de diffusion du mélange gazeux peut prendre la forme d'un double conduit qui débouche dans la deuxième cellule 22 en deux points E1, E2 de la paroi de la deuxième cellule. Les droites normales à la paroi auxdits points sont contenues dans des plans P1, P2 qui sont parallèles à l'axe de mesure 4 du dispositif et qui forment un angle droit entre eux, et chacun des points est situés dans un plan médian $P_M$ de la deuxième cellule qui est perpendiculaire à l'axe de mesure. Avec une telle configuration, les décalages de fréquence auxquels sont sujets les atomes de gaz noble et qui sont introduits par les effets quadrupolaires sont de signe contraire pour les deux plans P1, P2, et la dynamique de ces atomes est donc insensible jusqu'au deuxième ordre à ces effets.

Dans une autre variante de réalisation, la connexion 23 est réalisée au moyen d'une paroi poreuse, par exemple une paroi en verre poreux qui peut présenter une épaisseur inférieure à 2 mm et des pores ouvertes présentant des tailles comprises entre 100 nm et 100 $\mu$m.

L'enceinte peut classiquement être réalisée selon des techniques de soufflage de verre. En variante, elle peut être issue de gravure d'un substrat, et être ainsi fabriquée selon des procédés bien connus en micro-électronique. On a ainsi représenté sur les figures 3a et 3b deux exemples de telles enceintes micro-fabriquées, en vue de dessus selon un coupe réalisée au niveau de leur plan médian. L'enceinte de la figure 3a comprend un unique conduit capillaire, là où celle de la figure 3b en compte deux, C1 et C2, agencés conformément à la description ci-dessus de la figure 2. On a par ailleurs représenté sous la référence 9 sur la figure 3b un conduit de remplissage de l'enceinte, formé au niveau de la première cellule, et qui est scellé après remplissage.

Le dispositif selon l'invention comprend par ailleurs un régulateur thermique (non représenté). Ce régulateur peut être exploité afin de concentrer des inhomogénéités de température sur la paroi de la première cellule, avec notamment comme représenté sur la figure 3A la présence d'un point chaud 10 et la présence d'un point froid 11 permettant de concentrer la condensation et le dépôt de gouttelettes d'alcalin dans la première cellule.

## Revendications

**1.** Dispositif de détection de résonance magnétique nucléaire du type à pompage optique par échange de spin, comprenant une enceinte (2) contenant un mélange gazeux qui comprend un alcalin et deux espèces de gaz noble, un générateur (3) d'un champ magnétique statique orienté selon un axe de mesure (4) du dispositif, et un premier laser pompe (5) pour conférer un sens d'orientation à l'alcalin le long dudit axe de mesure, cette orientation étant transférée aux deux espèces de gaz noble par collision d'échange de spin,
**caractérisé en ce que** l'enceinte comprend une première cellule (21) agencée de manière à pouvoir être éclairée par le premier laser pompe (5), une deuxième cellule (22) et une connexion (23) de diffusion du mélange gazeux reliant la première et la deuxième cellule, et **en ce qu'**il comporte en outre un second laser pompe (7) pour éclairer la deuxième cellule et configuré pour orienter l'alcalin dans la deuxième cellule alternativement, et selon des périodes temporelles correspondantes, selon un sens identique et selon un sens opposé au sens d'orientation conféré à l'alcalin dans la première cellule par le premier laser pompe.

**2.** Dispositif selon la revendication 1, dans lequel les périodes temporelles correspondantes sont comprises entre une seconde et plusieurs dizaines de minutes.

**3.** Dispositif selon l'une des revendications 1 et 2, comprenant en outre un laser sonde (8) agencée de manière à pouvoir éclairer la deuxième cellule et un photodétecteur (6) recevant la lumière émise par le laser sonde après passage à travers la deuxième cellule.

**4.** Dispositif selon l'une des revendications 1 à 3, dans lequel la connexion comprend un conduit capillaire.

**5.** Dispositif selon la revendication 4, dans lequel le conduit capillaire présente un facteur de forme supérieur à 100 :1.

**6.** Dispositif selon l'une des revendications 1 à 5, dans lequel la connexion débouche dans la deuxième cellule en deux points (E1, E2) de la paroi de la deuxième cellule, les droites normales à la paroi auxdits points étant contenues dans des plans (P1, P2) qui sont parallèles à l'axe de mesure (4) du dispositif et qui forment un angle droit entre eux, et chacun desdits points étant situés dans un plan médian ($P_M$) de la deuxième cellule qui est perpendiculaire à l'axe de mesure.

**7.** Dispositif selon l'une des revendications 1 à 3, dans lequel la connexion est une paroi poreuse.

**8.** Dispositif selon l'une des revendications 1 à 7, dans lequel l'enceinte comprend un queusot uniquement au niveau de la première cellule.

**9.** Dispositif selon l'une des revendications 1 à 8, dans lequel l'enceinte est issue de gravure d'un substrat.

**10.** Dispositif selon l'une des revendications 1 à 9, comprenant en outre un régulateur thermique apte à conférer des inhomogénéités de température à la paroi de la première cellule.

**11.** Dispositif selon l'une des revendications 1 à 10, dans lequel les deux espèces de gaz noble sont les deux isotopes du xénon $^{129}Xe$ et $^{131}Xe$.

**12.** Centrale de navigation inertielle comprenant un dispositif selon l'une des revendications 1 à 11.

1
21
5
23
6
22
7
2
4
8
3

FIG. 1

P2
P1
C2
22
4
21
PM
E1
C1

FIG. 2

10
9
11
21
23
22
FIG. 3a

C2
E2
21
22
E1
C1
FIG. 3b

# RAPPORT DE RECHERCHE EUROPEENNE

Numéro de la demande
EP 17 18 8269

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 4 157 495 A (GROVER BRUCE C [US] ET AL) 5 juin 1979 (1979-06-05) * colonne 1, ligne 34 - colonne 3, ligne 14; figure 3 * | 1-12 | INV. G01C19/62 ADD. G01R33/26 |
| A | WO 81/00455 A1 (HUGHES AIRCRAFT CO [US]) 19 février 1981 (1981-02-19) * page 1, ligne 26 - page 3, ligne 32; figure 1 * | 1-12 | |
| A | US 8 698 493 B2 (WALKER THAD GILBERT [US] ET AL) 15 avril 2014 (2014-04-15) * abrégé * * colonne 2, ligne 29 - colonne 3, ligne 68 * * colonne 4, ligne 39 - colonne 4, ligne 67 * | 1-12 | |

DOMAINES TECHNIQUES RECHERCHES (IPC)

G01C
G01R

Le présent rapport a été établi pour toutes les revendications

1

| Lieu de la recherche | Date d'achèvement de la recherche | Examinateur |
|---|---|---|
| La Haye | 14 septembre 2017 | Pascheka, Patrick |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 17 18 8269

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-09-2017

| Document brevet cité au rapport de recherche | Date de publication | Membre(s) de la famille de brevet(s) | Date de publication |
|---|---|---|---|
| US 4157495 A | 05-06-1979 | AUCUN | |
| WO 8100455 A1 | 19-02-1981 | EP 0033340 A1 | 12-08-1981 |
| | | WO 8100455 A1 | 19-02-1981 |
| US 8698493 B2 | 15-04-2014 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 4157495 A
- US 8698493 B2


### Littérature non-brevet citée dans la description


- **T.XIA et al.** Polarization and hyperfine transitions of metastable Xe in discharge cells. *Physical Review,* Mars 2010, vol. 81 (3